# EUROPÄISCHE PATENTANMELDUNG

(11) **EP 1 347 575 A1**
(43) Veröffentlichungstag der Anmeldung: **24.09.2003**
(21) Anmeldenummer: 02027375.1
(22) Anmeldetag: 09.12.2002
(51) Int. Cl.: H03K 3/03

(54) **Digitaler Oszillator und Verfahren zur Erzeugung eines oszillierenden Signals**

(30) Priorität: 27.02.2002 DE 10208617
(71) Anmelder: ROBERT BOSCH GMBH, 70442 Stuttgart (DE)
(72) Erfinder: Hoetzel, Jürgen, 61197 Florstadt (DE); Kirchhof-Falter, Günther, 64342 Seeheim-Jugenheim (DE)

(57) **Zusammenfassung**

Die Erfindung betrifft ein Verfahren zur Erzeugung eines oszillierenden Signals mit folgenden Schritten:
- Initialisierung einer geradzahligen Anzahl von miteinander verketteten Invertern, so dass die Ausgänge der Inverter alternierend einen ersten logischen Wert und einen zweiten logischen Wert aufweisen,
- Eingabe eines Anregungs-Pulses in die Verkettung der Inverter zur Anregung der Oszillation, wobei die Länge des Anregungs-Pulses kleiner als die Laufzeit durch die Verkettung der Inverter ist.

Die Erfindung betrifft ferner einen digitalen Oszillator mit einer geradzahligen Anzahl von miteinander verketteten Invertern (6, 7, 8, 9, 10, 11, 12, 13)

## Beschreibung

Die Erfindung betrifft einen digitalen Oszillator und ein Verfahren zur Erzeugung eines oszillierenden Signals.

Aus dem Stand der Technik ist es an sich bekannt, mittels einer digitalen Schaltung einen Oszillator zu realisieren. Allgemein üblich ist es hierzu eine ungeradzahlige Anzahl von Invertern zu kaskadieren, um einen Ring-Oszillator zu erhalten.

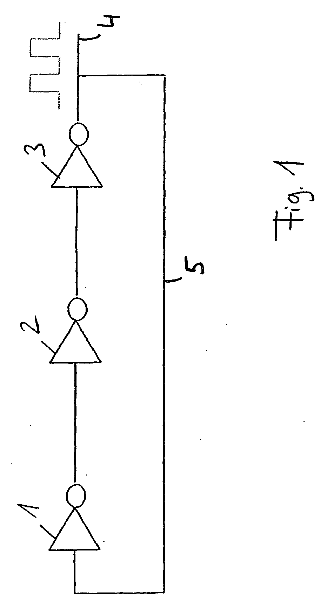

Die Figur 1 zeigt einen entsprechenden aus dem Stand der Technik bekannten Oszillator. Die Inverter 1, 2 und 3 sind in Reihe geschaltet. Der Ausgang des Oszillators 3 ist über die Leitung 5 auf den Eingang des Inverters 1 zurückgeführt. Dadurch entsteht ein Ring-Oszillator mit dem Ausgang 4. Für die Funktion des Ring-Oszillators entscheidend ist, dass eine ungeradzahlige Anzahl von Invertern miteinander verkettet ist.

Der Erfindung liegt die Aufgabe zu Grunde einen verbesserten digitalen Oszillator und ein verbessertes Verfahren zur Erzeugung eines oszillierenden Signals zu schaffen.

Die der Erfindung zu Grunde liegende Aufgabe wird jeweils mit den Merkmalen der unabhängigen Patentansprüche gelöst. Bevorzugte Ausführungsformen der Erfindung sind in den abhängigen Patentansprüche angegeben.

Die Erfindung erlaubt es, einen digitalen Oszillator, insbesondere einen digitalen Ring-Oszillator, mit einer geradzahligen Anzahl von verketteten Invertern zu schaffen. Dies erlaubt es insbesondere einen digitalen Ring-Oszillator zu schaffen, dessen Anzahl von verketteten Invertern eine Zweierpotenz ist.

Werden beispielsweise zweiunddreißig Inverter miteinander verkettet, so können die einzelnen Ausgänge der Inverter unmittelbar abgegriffen werden, um ein 32 Bit langes Datenwort zu erhalten. Dieses kann dann als Eingangssignal für eine digitale Schaltung dienen, deren Eingang die entsprechende Bit-Breite aufweist. Auf diese Art und Weise lässt sich beispielsweise ein Frequenzgenerator oder ein Pattern-Generator realisieren. Ein weiteres Anwendungsgebiet ist die Realisierung einer Verzögerungsleitung durch selektiven Abgriff der Ausgänge verschiedener Inverter über eine Multiplex-Matrix.

Um die geradzahlige Anzahl von miteinander verketteten Invertern zum Schwingen zu bringen, ist es zunächst erforderlich, die Ausgänge der einzelnen Inverter in einen initialen Zustand zu versetzen. Nach einer bevorzugten Ausführungsform der Erfindung geschieht dies so, dass zur Initialisierung des digitalen Oszillators die Verkettung der Inverter unterbrochen wird, um durch mehrfache Taktung der Schaltung diese in einen definierten Zustand zu versetzen. Vorzugsweise haben die Ausgänge der Inverter in diesem initialen Zustand alternierende logische Werte.

Nach einer bevorzugten Ausführungsform der Erfindung wird die Unterbrechung der Verkettung der Inverter zur Initialisierung so erreicht, dass zumindest einer der Inverter einen Steuereingang aufweist, der es erlaubt, den Ausgang dieses Inverters in einen bestimmten logischen Zustand zu versetzen, der unabhängig von dem Eingang des Inverters ist.

Nach einer weiteren bevorzugten Ausführungsform der Erfindung hat zumindest einer der Inverter einen Eingang zur Eingabe eines Anregungs-Pulses, um die Schwingung des digitalen Oszillators anzuregen. Die Länge des Anregungs-Pulses wird dabei so gewählt, dass dieser kleiner als die Signallaufzeit durch die Verkettung der Inverter ist. Vorzugsweise wird die Länge des Anregungs-Pulses so gewählt, dass diese zwischen ¼ und ¾, insbesondere ½, der Laufzeit durch die verketteten Inverter beträgt.

Nach einer weiteren bevorzugten Ausführungsform der Erfindung kann über einen Steuereingang eines der Inverter der digitale Oszillator in einen Sleep-Mode gebracht werden. Über diesen Steuereingang ist es möglich, den Oszillator anzuhalten, und somit eine geringe Stromaufnahme zu ermöglichen. Dies ist insbesondere bei Automobil-Anwendungen von besonderer Bedeutung, um bei abgeschalteten Motor die Batterie-Kapazität zu schonen.

Im Weiteren werden bevorzugten Ausführungsbeispiele der Erfindung mit Bezugnahme auf die Zeichnungen näher erläutert. Es zeigen:
- Figur 1: einen Ring-Oszillator, wie er an sich aus dem Stand der Technik bekannt ist,
- Figur 2: ein Ausführungsbeispiel für einen erfindungsgemäßen Ring-Oszillator,
- Figur 3: ein Ersatz-Schaltbild für die Belastung der Ausgänge der Inverter,
- Figur 4: ein Blockdiagramm und ein Signaldiagramm zur Erzeugung eines Anregungs-Pulses,
- Figur 5: eine Anwendung des digitalen Oszillators der Figur 2, wobei Ausgänge der Inverter über eine Multiplex-Matrix abgegriffen werden.

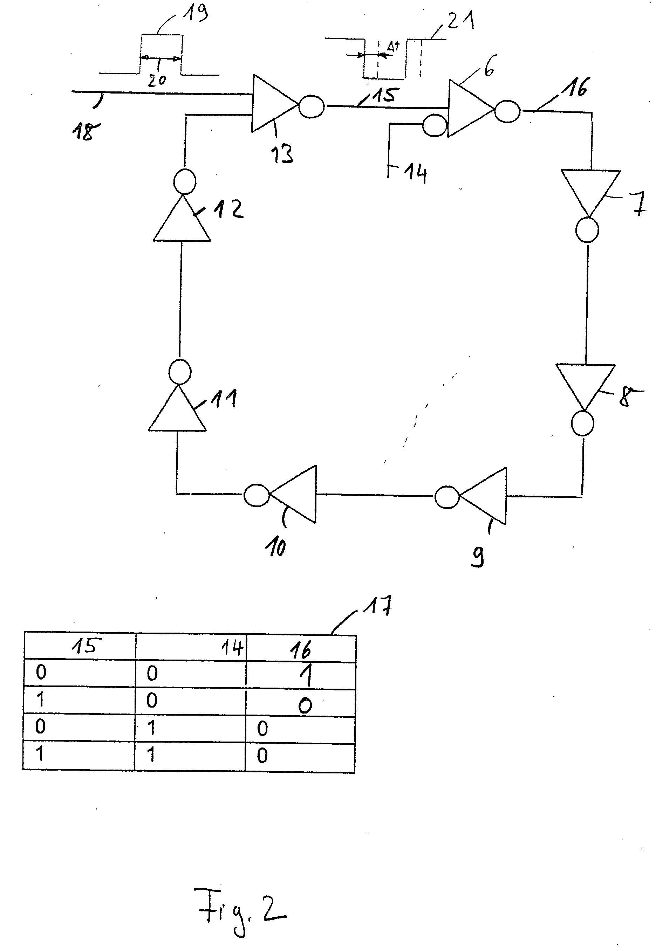

Die Figur 2 zeigt einen digitalen Ring-Oszillator, der aus einer Verkettung einer Anzahl von acht Invertern 6, 7, 8, 9, 10, 11, 12 und 13 besteht.

Der Inverter 6 hat einen Steuereingang 14. Der Eingang 15 des Inverters 6 ist mit dem Ausgang des Inverters 13 verbunden. Der Ausgang des Inverters 6 ist mit 16 bezeichnet.

Wenn das Signal an dem Steuereingang 14 logisch Null ist, wirkt der Inverter 6 als herkömmlicher Inverter, das heißt das Signal an dem Eingang 15 wird invertiert.

Wenn hingegen das Signal an dem Steuereingang 14 logisch Eins ist, so wird der Inverter 6 "disabled", das heißt, der Augang 16 des Inverters 6 nimmt dann einen logischen Wert an, der von dem an dem Eingang 15 des Inverters 6 anliegenden logischen Wert unabhängig ist.

Liegt also an dem Steuereingang 14 logisch Eins an, so hat der Ausgang 16 unabhängig davon, ob der Eingang 15 logisch Null oder logisch Eins ist, immer einen bestimmten logischen Wert - im dem betrachteten Ausführungsbeispiels ist dieser Wert logisch Null. Durch entsprechende Ansteuerung des Inverters 6 über den Steuereingang 14 kann also die Verkettung der Inverter 6 bis 13 an dieser Stelle unterbrochen werden.

Eine solche Unterbrechung kann dazu dienen, den digitalen Oszillator in einen initialen Zustand zu versetzen oder um den Oszillator anzuhalten oder um die Schaltung in einen Sleep-Mode zu bringen.

Die Funktionsweise des Inverters 6 ist in der Tabelle 17 der Figur 2 angegeben. Die erste Spalte der Tabelle 17 zeigt die logischen Zustände des Eingangs 15; die zweite Spalte die logischen Zustände des Steuereingangs 14 und die dritte Spalte zeigt die entsprechenden logischen Zustände des Ausgangs 16.

Der Inverter 13 hat einen Anregungs-Eingang 18 zur Eingabe eines Anregungs-Pulses 19. Der Anregungs-Puls 19 hat eine Pulslänge 20. Die Pulslänge 20 ist so gewählt, dass diese kleiner als die Laufzeit des Anregungs-Pulses 19 durch die Inverter 6 bis 13 ist. Vorzugsweise ist die Pulslänge 20 so gewählt, dass diese zwischen ¼ und ¾ der Gesamtlaufzeit durch die Inverter 6 bis 13 beträgt, vorzugsweise etwa die Hälfte der Gesamtlaufzeit.

Wenn der Anregungs-Puls 19 in den Inverter 13 eingegeben wird, so resultiert daraus an dem Eingang 15 des Inverters 6, welcher gleichzeitig der Ausgang des Inverters 13 ist, der invertierte Anregungs-Puls 21 und zwar nach der Laufzeit Δt durch den Inverter 13.

Zur Erzeugung eines oszillierenden Signals wird der digitale Oszillator der Figur 2 zunächst in einen initialen Zustand versetzt. Dazu wird die Verkettung der Inverter 6 bis 13 für die Durchführung der Initialisierung unterbrochen. In dem hier betrachteten Ausführungsbeispiel erfolgt dies so, dass an den Steuereingang 14 des Inverters 6 eine logische Eins angelegt wird, um den Inverter 6 zu "disablen" und so die Verkettung der Inverter 6 bis 13 an der Stelle des Inverters 6 zu unterbrechen.

Durch das Anlegen von logisch Eins an dem Steuereingang 14 ist der Ausgang 16 des Inverters 6 auf einem definierten logischen Wert und zwar unabhängig von dem Eingang 15. In dem hier betrachteten Ausführungsbeispiel ist dieser logische Wert gleich logisch Null. Durch Takten des digitalen Oszillators propagiert dieser definierte logische Wert durch die Reihenschaltung der Inverter 6 bis 13, so dass schließlich ein definierter initialer Zustand erreicht wird.

Dieser definierte initiale Zustand sieht in dem hier betrachteten Beispielsfall so aus, dass die Ausgänge der Inverter alternierend unterschiedliche logische Werte aufweisen, das heißt der Inverter 6 hat als Ausgangswert an seinem Ausgang 16 den logischen Wert Null, der Inverter 7 den logischen Wert Eins, der Inverter 8 den logischen Wert Null, der Inverter 9 den logischen Wert Eins, der Inverter 10 den logischen Wert Null, der Inverter 11 den logischen Wert Eins, der Inverter 12 den logischen Wert Null und der Inverter 13 den logischen Wert Eins.

Nach der erfolgten Initialisierung kann dann der Steuereingang 14 von logisch Eins auf logisch Null gesetzt werden. Dadurch ist dann die Unterbrechung der Verkettung aufgehoben und die Ringstruktur wieder hergestellt. Diese befindet sich zunächst in einem stabilen Zustand, da ja die Ausgänge der Inverter 6 bis 13 alternierend die logischen Werte Null und Eins aufweise. Ein solcher stabiler Zustand ist aufgrund der geradzahligen Anzahl von Invertern 6 bis 13 möglich. Dieser Zustand wird auch als sleep Mode bezeichnet, da die Leistungsaufnahme in diesem Zustand minimal ist.

Dieser stabile Zustand wird durch Eingabe des Anregungs-Pulses 19 auf den Anregungs-Eingang 18 des Inverters 13 verlassen. Nach einmaliger Eingabe des Anregungs-Pulses 19 schwingt der digitale Ring-Oszillator mit einer stabilen Resonanz-Frequenz und mit einer exakten Schwingungsdauer über jedem Glied der Oszillator-Kette, das heißt über jedem der Inverter 6 bis 13.

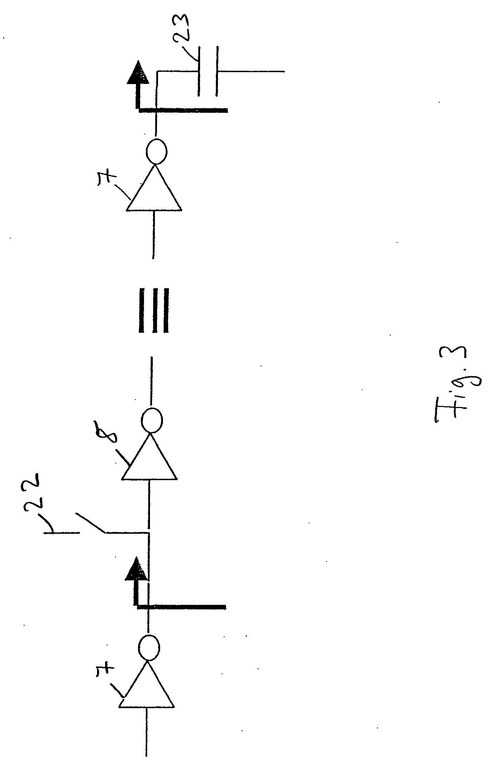

Grundsätzlich ist es möglich an jedem beliebigen Punkt in der Verkettung der Inverter 6 bis 13 ein oszillierendes Signal abzugreifen. Vorzugsweise erfolgt dies so, dass die Belastung jedes der Inverter 6 bis 13 mit einer Eingangsimpedanz im Wesentlichen gleich ist. Die Figur 3 zeigt ein entsprechendes Ersatzschaltbild:

An dem Ausgang des Inverters 7 wird das Ausgangssignal des Inverters 7 über eine Leitung 22 abgegriffen. Die Belastung des Ausgangs des Inverters 7 mit einer Impedanz in Pfeilrichtung ist kapazitiv, wie das entsprechende Ersatzschaltbild zeigt. Diese kapazitive Belastung wird durch den Kondensator 23 symbolisiert.

Vorzugweise sind in diesem Fall sämtliche Ausgänge der Inverter 6 bis 13 kapazitiv belastet und zwar mit einer Kapazität, die dem Kondensator 23 entspricht. Durch die gleichmäßige Belastung von jedem Inverter in der Oszillator-Kette wird eine besonders stabile Resonanz erzeugt.

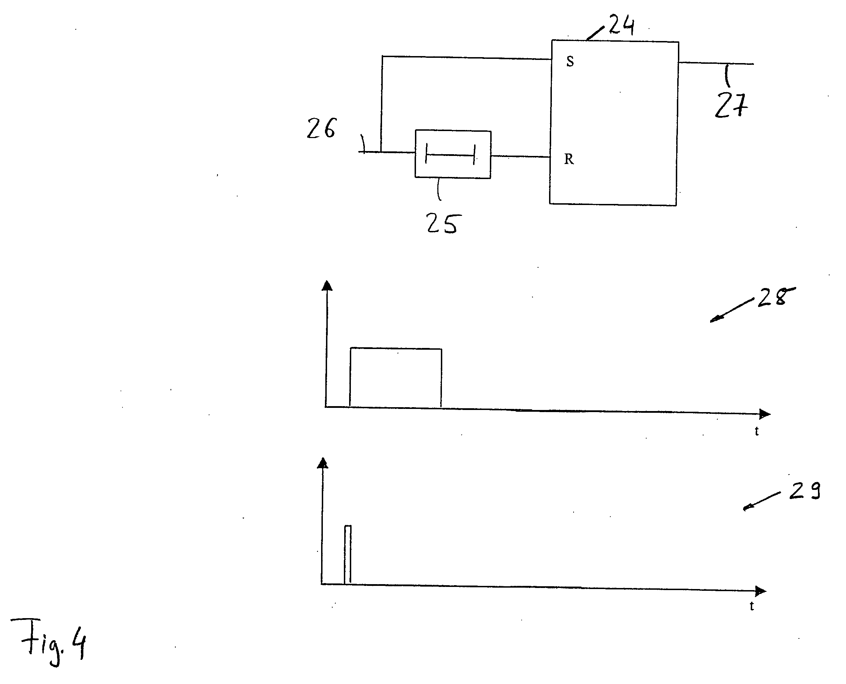

Die Figur 4 zeigt ein Blockschaltbild einer Schaltung zur Erzeugung des Anregungs-Pulses (vgl. Anregungs-Puls 19 der Figur 2). Die Schaltung weist ein SR-Flip-Flop 24 auf. Der R-Eingang des SR-Flip-Flops 24 ist mit einem Laufzeitglied 25 verbunden. Das andere Ende des Laufzeitglieds 25 stellt den Eingang 26 der Schaltung dar. Dieser ist ferner mit dem S-Eingang des SR-Flip-Flops 24 verbunden. Das SR-Flip-Flop 24 hat einen Ausgang 27.

Das Signal-Diagramm 28 zeigt den Verlauf eines Signals, welches an den Eingang 26 der Schaltung angelegt wird. Das Signal-Diagramm 29 zeigt den entsprechenden Signalverlauf an dem Ausgang 27 der Schaltung. Das Signal an dem Ausgang 27 kann als Anregungs-Puls 19 verwendet werden.

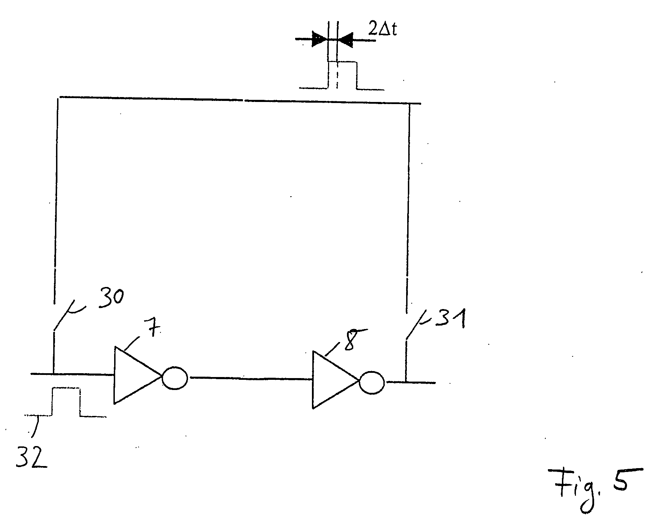

Die Figur 5 zeigt einen Anwendungsfall der Schaltung der Figur 2, bei dem mittels einer Multiplex-Matrix, die die Schalter 30 und 31 sowie weitere der Übersichtlichkeit halber in der Figur 5 nicht gezeigte Schalter aufweist, realisiert ist. Die Multiplex-Matrix erlaubt es grundsätzlich beliebige Ausgänge der Inverter 6 bis 13 abzufragen, um die entsprechenden Signalausgänge einer Verwendung zuzuführen.

In dem hier betrachteten Beispielfall werden die Signale an dem Eingang des Inverters 7 und an dem Ausgang des Inverters 8 abgegriffen. Der Puls 32 an dem Eingang des Inverters 7 wird dabei um eine Zeitdauer von 2 Δt verzögert.

### Bezugszeichenliste

- Inverter: 1
- Inverter: 2
- Inverter: 3
- Ausgang: 4
- Leitung: 5
- Inverter: 6
- Inverter: 7
- Inverter: 8
- Inverter: 9
- Inverter: 10
- Inverter: 11
- Inverter: 12
- Inverter: 13
- Steuereingang: 14
- Eingang: 15
- Ausgang: 16
- Tabelle: 17
- Anregungs-Eingang: 18
- Anregungs-Puls: 19
- Pulslänge: 20
- Anregungs-Puls: 21
- Leitung: 22
- Kondensator: 23
- SR-Flip-Flop: 24
- Laufzeitglied: 25
- Eingang: 26
- Ausgang: 27
- Signaldiagramm: 28
- Signaldiagramm: 29
- Schalter: 30
- Schalter: 31
- Puls: 32

## Patentansprüche

1. Digitaler Oszillator mit einer geradzahligen Anzahl von miteinander verketteten Invertern (6, 7, 8, 9, 10, 11, 12, 13).

2. Digitaler Oszillator nach Anspruch 1 mit Mitteln (14) zur Unterbrechung der Verkettung der Inverter zur Initialisierung des Oszillators.

3. Oszillator nach Anspruch 1 oder 2, wobei ein erster Inverter (6) der Verkettung der Inverter einen Steuereingang (14) aufweist, um die Inverter in einen initialen Zustand zu versetzen.

4. Digitaler Oszillator nach Anspruch 3, wobei der Steuereingang des ersten Inverters so ausgebildet ist, dass bei Anlegen eines ersten Signals der Ausgang (16) des ersten Inverters einen ersten logischen Wert annimmt, der von dem an dem Eingang (15) des ersten Inverters anliegenden logischen Wert unabhängig ist.

5. Digitaler Oszillator nach einem der vorhergehenden Ansprüche 1 bis 4, wobei die Ausgänge der Inverter in dem initialen Zustand alternierend den ersten logischen Wert und einen zweiten logischen Wert aufweisen.

6. Digitaler Oszillator nach einem der vorhergehenden Ansprüche 1 bis 5, wobei ein zweiter Inverter (13) der Verkettung der Inverter einen Anregungs- Eingang (18) zur Eingabe eines Anregungs-Puls (19) aufweist.

7. Elektronische Schaltung mit einem digitalen Oszillator nach einem der vorhergehenden Ansprüche 1 bis 6, wobei die Belastung der Ausgänge der Inverter mit jeweils einer Impedanz (23) im Wesentlichen gleich ist.

8. Elektronische Schaltung nach Anspruch 7, wobei es sich um einen Frequenzgenerator oder einen Pattern-Generator handelt.

9. Elektronische Schaltung nach Anspruch 7 oder 8, mit Multiplex-Mitteln (30, 31), vorzugsweise einer Multiplex-Matrix, zum selektiven Auslesen der Ausgänge von Invertern der Verkettung.

10. Verfahren zur Erzeugung eines oszillierenden Signals mit folgenden Schritten:
- Initialisierung einer geradzahligen Anzahl von miteinander verketteten Invertern, so dass die Ausgänge der Inverter alternierend einen ersten logischen Wert und einen zweiten logischen Wert aufweisen,
- Eingabe eines Anregungs-Pulses in die Verkettung der Inverter zur Anregung der Oszillation, wobei die Länge des Anregungs-Pulses kleiner als die Laufzeit durch die Verkettung der Inverter ist.

11. Verfahren nach Anspruch 10, wobei zur Initialisierung der Inverter die Verkettung an mindestens einer Stelle unterbrochen wird.

12. Verfahren nach Anspruch 10 oder 11, wobei zur Initialisierung der Inverter ein erster Inverter so angesteuert wird, dass der Ausgang dieses Inverters einen ersten logischen Wert unabhängig von dem logischen Wert des Eingangs dieses Inverters annimmt.

13. Verfahren nach einem der vorhergehenden Ansprüche 10, 11 oder 12, wobei die Ausgänge der verketteten Inverter jeweils im Wesentlichen mit derselben Impedanz belastet werden.

14. Verfahren nach einem der vorhergehenden Ansprüche 10 bis 13, wobei durch Multiplexen die Ausgänge der Inverter ausgelesen werden.
